# EUROPEAN PATENT SPECIFICATION

(11) **EP 0 395 149 B1**
(45) Date of publication and mention of the grant of the patent: **28.06.1995**
(21) Application number: 90200990.1
(22) Date of filing: 19.04.1990
(51) Int. Cl.: G01R 31/26, G01R 31/30

(54) **Method and device for accelerated determining of ageing of one or more elements with an electromagnetic ageing parameter**
Verfahren und Anordnung zur beschleunigten Bestimmung der Alterung von einem oder mehreren Elementen mit einem elektromagnetischen Alterungsparameter
Méthode et dispositif pour la détermination accélérée du vieillissement d'éléments avec un paramètre de vieillissement électromagnétique

(30) Priority: 19.04.1989 NL 8900982; 22.11.1989 NL 8902891
(43) Date of publication of application: 31.10.1990
(73) Proprietor: INTERUNIVERSITAIR MICROELEKTRONICA CENTRUM VZW, 3030 Leuven-Heverlee (BE); LIMBURGS UNIVERSITAIR CENTRUM, B-3610 Diepenbeek (BE)
(72) Inventor: Stals, Lambert Mathias Maria, B-3610 Diepenbeek (DE); Roggen, Jean Joseph Marie, B-3920 Lummen (BE); De Schepper, Luc Irena, B-3500 Hasselt (BE); De Ceuninck, Ward Aimé Stefan, B-8580 Avelgem (BE)
(74) Representative: Land, Addick Adrianus Gosling

(56) References cited:
- EP-A- 0 168 518
- GB-A- 970 426
- US-A- 2 375 154
- US-A- 3 677 329
- US-A- 3 823 685
- US-A- 4 554 437
- US-A- 4 777 434
- US-A- 4 782 291
- FREQUENZ, vol. 35, no. 7, July 1987, pages 188-190, Berlin, DE; K. HOFFMANN etal.: "Ein neues Verfahren zur Bestimmung der Lebensdauer von elektronischenBauelementen"
- MEASUREMENT TECHNIQUES, vol. 24, no. 9, September 1981, pages 762-767, PlenumPublishing Corp., New York, US; V.YA. CHEREPANOV: "Simultaneous measurement ofthe integral emittance and the temperature dependence of electrical resistanceby a modulation method"

## Description

Importance is increasingly being attached to the early detection of ageing processes in electrical components and the like, such as resistances in thin- or thick-film techniques, YBaCuO films or other ceramic (superconducting) layers, Cu and Al wires or alloys thereof used when bonding I.Cs., AL. Au and Cu interconnections, flip-chip and bump connections, amorphous metal alloys, quasi crystals and/or soldered (Pb/Si) melting fuses, etc.

For the accelerated ageing of such elements with an electromagnetic ageing parameter (DC or AC impedance, a magnetic property, such as the shape of the hysteresis curve etc.), they are exposed according to the state of the art for a predetermined time to a predetermined, raised temperature, whereafter the change in impedance of such an element is determined, from which prognoses can be made as to the useful life that can be expected of such electrical components.

Because of the time-consuming character of placing such an element with ageing parameters in an environment with raised temperature, such as an oven, and subsequently measuring the changed parameter, whereafter this cycle is repeated, the above stated method is disadvantageous particularly for systems wherein a small change of the parameters occurs. With the known method the measurement error amounts to for instance 100 ppm; an ageing to 10,000 ppm is then necessary, if predictions on the basis of extrapolations of the change in the parameter are to be made with any reliability. Measuring wires, such as current and voltage wires have to be connected and disconnected again each time, while a little time is necessary in each case to reach a determined stability and temperature. The instability of the temperature when switching on and off moreover causes inaccuracies in such measurements. Such measurements are carried out under various conditions:
- in He atmosphere;
- in air;
- in polluted air, of particular importance for sensors for determining the degree of air pollution;
- in O₂ atmosphere; or
- in an atmosphere of moistened air.

A known method is described in the article by K. Hoffmann et al.: "Ein neues Verfahren zur Bestimmung der Lebensdauer von elektronischen Bauelementen", Frequenz vol. 35, no. 7, July 1987, pages 188-190, Berlin. In this known method for determining the change of an electromagnetic ageing parameter on one or more elements having such parameter, such element is placed in an oven at a predetermined temperature, wherein the measurement of the parameter at this temperature is performed. No accurate heating of the sample, is described with this known system whereby inaccuracies in such system amount to 0.25% of the measuring results which is too high for obtaining reliable results within a reasonable time period.

US-A-2375154 shows a resistance wound electric furnace for high temperature heating, as such however lacking the features of the apparatus and method of the present invention for accelerated determining of an ageing of one or more elements with an electromagnetic ageing parameter.

The present invention has for its object to provide an apparatus and a method which form an improvement to the above stated method, in the sense that accelerated ageing can be carried out with greater reliability, with greater resolution and/or within a shorter time.

The present invention provides an apparatus for determining the impedance change of one or more elements with an electromagnetic ageing parameter, comprising:
- an oven with heating means;
- a holder for the element and disposed in the interior of the oven;
- a temperature sensor disposed in the interior of the oven;
- a passage opening arranged in the oven for passage of connecting wires for the element; and
- a control unit which is connected to the temperature sensor and to the heating means for controlling the temperature inside the oven, **characterized in that**
- the oven has a substantially tubular form and a single thin wall;
- the heating means comprise a heating wire closely wound around the oven; and
- the electrical supply to the heating wire is controlled such by the control unit that an accuracy of 0.001°C for the temperature in the interior of the tubular oven is obtained.

The present invention further provides a method for determining the impedance change of an electromagnetic ageing parameter of one or more elements having such a parameter, wherein the element is placed in an oven at a predetermined temperature, wherein a measurement of the impedance of the elements at this temperature is performed, and wherein temperature changes recorded by a temperature sensor in the interior of the oven are fed back to heating means for heating the oven, **characterized in that** heating is performed by means of a heating wire closely wound around the oven of substantially tubular form and having a single thin wall, and in that the temperature of the interior of the oven is regulated by a control unit with an accuracy of 0.001°C of the temperature in the interior of the oven.

The greater resolution can only be realized using a very stable oven, so that the changes of the electromagnetic quantity to be determined as a result of temperature fluctuations are negligible relative to the changes as a result of the ageing phenomena which occur in the component under examination.

The very stable oven temperature coupled with a high resolution of the measuring equipment permits distinguishing of the physical processes forming the basis of the ageing phenomena.

The method furthermore has the advantage that it can be used as a non-destructive test, and optionally as production or quality control.

Further features, details and advantages of the present invention will be elucidated in the light of a description of preferred embodiments thereof with reference to the annexed drawings, in which:
figure 1 shows a perspective view of a first preferred embodiment of a device according to the present invention;
figure 2 shows a graph for elucidation of a preferred embodiment of the method according to the present invention; and
figure 3 shows a second preferred embodiment of the device according to the present invention.

A substantially tubular oven 1 comprises a stainless steel wall 2 (thickness approximately 0.38 mm) around which is wound a chrome vanadium wire 3 with a coating of quartz. Because of the thin wall and the quartz coating of the chrome vanadium wire (such a wire exhibits a small temperature dependence) a rapid control of the temperature in the interior of the tubular oven 1 is possible. Disposed in the tubular oven 1 is a holder 4 on which is situated an element with ageing parameter 5, which in the embodiment shown is a housing for an integrated circuit. The bundled connecting wires 7 are guided through a flange 6, wherein these wires are fed through integrally without being broken and are bonded in Araldite adhesive. Arranged in the end flange 9 is a temperature sensor 8 for measuring the internal temperature in the tubular oven. An inert gas, air or oxygen can be admitted into the tubular oven.

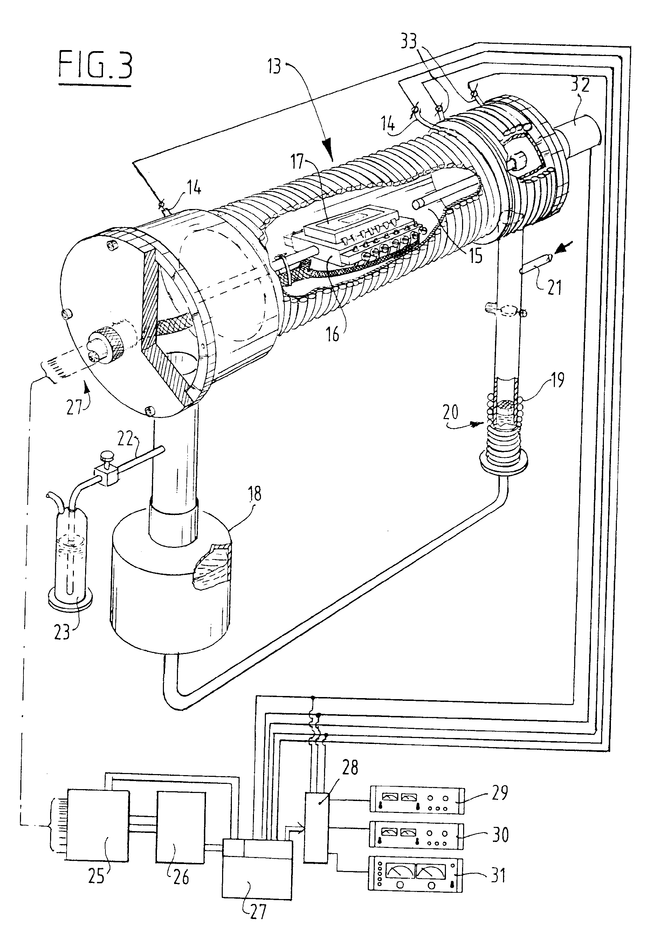

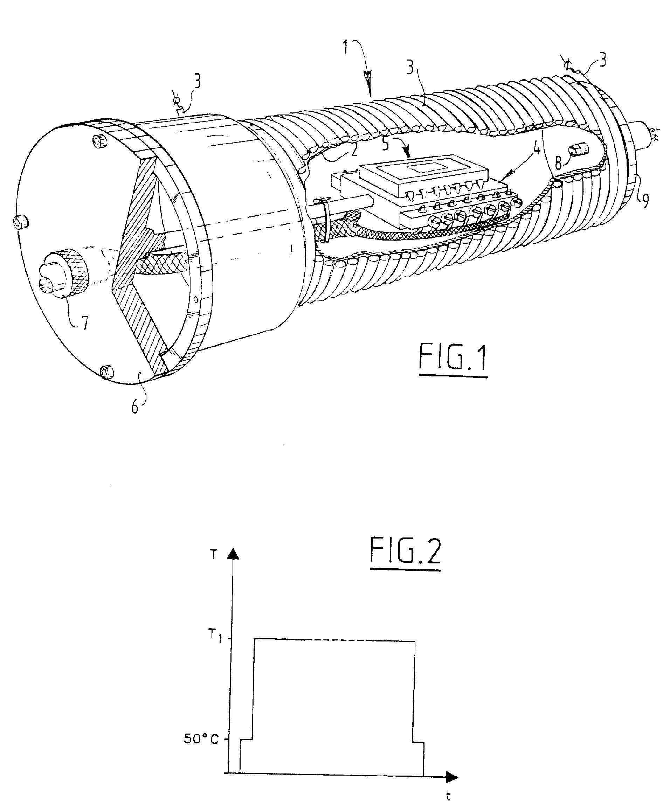

Using the resistor 3 the temperature in the oven 1 is for instance first brought to 50°C (fig. 2), wherein in this embodiment a measurement is performed on the resistance value of the element 5. In addition, a series of measurements are made at temperature T₁, which can amount for instance to 260°C (see embodiment of fig. 3) or 800-1,000°C (fig. 2), whereafter during cooling a measurement is again made at 50°C.

A tubular oven 13 (fig. 3) is provided with a bifilar winding resistance wire 14 to further increase the speed regulation of the temperature prevailing in the tubular oven 13. This temperature is measured with a temperature sensor 15 disposed close to a holder 16 for an element with resistance value 17 - in a manner not shown, but preferably clamped fixedly thereon - and preferably comprises a Pt-100 resistor which produces a more accurate measurement of a thermocouple. Also coupled with the tubular oven 13 (with a wall thickness of 0.25 mm) is a water reservoir 18 as well as an evaporating unit 20 provided with a resistance wire 19. A gas can further be carried into the tubular oven 13 via a supply 21. A gas discharge 22 is provided with a gas water bottle 23 in order to maintain pressure in the oven and keep the mass flow of the gas constant in a simple manner. A different mass flow meter can of course also be used therefor.

The schematically indicated connecting wires 24 for the component, in this embodiment with a resistance value, are coupled via a multiplexer 25 to a digital multimeter 26 with a control unit 27 such as a personal computer. This is in turn coupled via a control unit 28 to supplies 29, 30 and 31, which are respectively for supplying the resistance wire 14, for a front oven 32 arranged in the present embodiment which is provided with connections 33 for sensing, and for the evaporating unit 20.

In the front oven 32 (provided in a manner not shown with a temperature and humidity sensor) an air atmosphere of 85% humidity at 85°C is usually developed in order to comply for instance with prescribed conditions.

The connecting wires 24 are preferably insulated with a kapton covering in the embodiment shown in figure 3 (temperature approximately 260°C), but at higher temperatures (800-1,000°C) these will usually be arranged without insulation or with quartz coating. Four wires are typically used per measurement (four-point measurement, 2 current wires and 2 voltage wires).

If the temperature in the space in which the above described preferred embodiment of the method according to the present invention is performed varies only relatively slowly (for instance less than 1°C/hour), such as for instance in a non-conditioned space, the oven temperature can be regulated with an accuracy of 0.001°C.

Thermo-electric potential is preferably avoided as far as possible (for instance < 10»V/°C). Preferably wires are connected with clamp connections, while the multiplexing unit is provided with relays and coils, wherein the thermoelectric voltages amount to less than 1»V/10°C.

The arrangement schematically indicated in figure 3 preferably includes an algorithm which prevents measurements being made on the element with ageing parameter when too great a deviation of the temperature measured by the sensors occurs. The control for the supply voltages does not react to such possibly erroneous measurements, whereby a more stable control is obtained. A newly read value for the temperature is compared for this purpose with the average of the three previous temperature values in the oven.

Because of the extreme temperature stability of the above described preferred embodiment of the present invention, measurements can be performed with high resolution, for instance within 5-100 ppm of the total quantity to be measured; a prediction of the ageing process on the basis of extrapolations of the measured values are thus possible within a reasonable measuring time (for instance 100-1,000 hours), while a better insight is obtained into the functionality of the underlying physical processes.

Although the above described embodiments relate to ageing processes of an element with DC resistance values, the present invention according to the annexed claims can also be applied to capacitance (or induction) measurements and/or other electromagnetic quantities and additionally under various types of load, such as:
- mechanical tensile strain (off-chip connections);
- current load (for the purpose of studies into electron migration), etc.

## Claims

1. An apparatus for determining the impedance change of one or more elements (5; 17) with an electromagnetic ageing parameter, comprising:
- an oven (1; 13) with heating means;
- a holder (4; 16) for the element and disposed in the interior of the oven (1; 13);
- a temperature sensor (8; 15) disposed in the interior of the oven (1; 13);
- a passage opening arranged in the oven for passage of connecting wires (7; 24) for the element; and
- a control unit (28) which is connected to the temperature sensor (8; 15) and to the heating means for controlling the temperature inside the oven, **characterized in that**
- the oven (1; 13) has a substantially tubular form and a single thin wall;
- the heating means comprise a heating wire (3; 14) closely wound around the oven; and
- the electrical supply to the heating wire (3; 14) is controlled such by the control unit that an accuracy of 0.001°C for the temperature in the interior of the tubular oven is obtained.

2. A method for determining the impedance change of an electromagnetic ageing parameter of one or more elements (5; 17) having such a parameter, wherein the element (5; 17) is placed in an oven (1; 13) at a predetermined temperature, wherein a measurement of the impedance of the elements at this temperature is performed, and wherein temperature changes recorded by a temperature sensor (8; 15) in the interior of the oven are fed back to heating means for heating the oven, **characterized in that** heating is performed by means of a heating wire (3; 14) closely wound around the oven (1; 13) of substantially tubular form and having a single thin wall, and in that the temperature of the interior of the oven is regulated by a control unit with an accuracy of 0.001°C of the temperature in the interior of the oven.

3. An apparatus according to claim 1, wherein the thin wall is of stainless steel.

4. An apparatus according to claim 1 or 2 wherein the temperature sensor is a Pt resistance.

5. An apparatus according to any of claims 1, 2 or 3, provided with a second oven for delivering a moistened atmosphere into the first oven.

## Patentansprüche

1. Vorrichtung zur Bestimmung des Impedanzwechsels bzw. der Impedanzänderung eines oder mehrerer Elemente (5; 17) mit einem elektromagentischen Alterungsparameter, mit:
- einem Ofen (1; 13) mit Heizmitteln;
- einem Halter (4; 16) für das Element, welcher im Inneren des Ofens (1; 13) angeordnet ist;
- einem Temperaturfühler (8; 15), welcher im Inneren des Ofens (1; 13) angeordnet ist;
- einer Durchgangsöffnung, welche in dem Ofen angeordnet ist, um Verbindungsdrähte (8; 15) für das Element durchzuführen; und
- einer Steuereinheit (28), die mit dem Temperaturfühler (8; 15) und den Heizmitteln verbunden ist, um die Temperatur innerhalb des Ofens zu steuern, dadurch gekennzeichnet, daß
- der Ofen (1; 13) im wesentlichen rohrförmig ist und eine einzige dünne Wand aufweist;
- die Heizmittel einen Heizdraht (3; 14) umfassen, der eng um den Ofen gewickelt ist; und
- die elektrische Versorgung des Heizdrahtes (3; 14) so von der Steuereinheit gesteuert wird, daß eine Genauigkeit von 0,001°C für die Temperatur im Inneren des rohrförmigen Ofens erreicht wird.

2. Verfahren zur Bestimmung des Impedanzwechsels bzw. der Impedanzänderung eines elektromagnetischen Alterungsparameters eines oder mehrerer Elemente (5; 17), die einen solchen Parameter aufweisen, wobei das Element (5; 17) bei einer vorgegebenen Temperatur in einem Ofen (1; 13) plaziert wird, eine Messung der Impedanz der Elemente bei dieser Temperatur durchgeführt wird, und Temperaturwechsel, die von einem Temperaturfühler (8; 15) im Inneren des Ofens aufgezeichnet werden, an die Heizmittel zum Heizen des Ofens zurückgeführt werden, dadurch gekennzeichnet, daß das Heizen mittels eines Heizdrahtes (3; 14) durchgeführt wird, welcher eng um den Ofen (1; 13) gewickelt ist, der im wesentlichen rohrförmig ist und eine einzige dünne Wand aufweist, und dadurch, daß die Temperatur im Inneren des Ofens von einer Steuereinheit mit einer Genauigkeit von 0,001°C der Temperatur im Inneren des Ofens reguliert wird.

3. Vorrichtung nach Anspruch 1, in welcher die dünne Wand aus Edelstahl ist.

4. Vorrichtung nach Anspruch 1 oder 2, in welcher der Temperaturfühler ein Pt-Widerstand ist.

5. Vorrichtung nach einem der Ansprüche 1, 2 oder 3, wobei diese mit einem zweiten Ofen zur Lieferung einer befeuchteten Atmosphäre in den ersten Ofen versehen ist.

## Revendications

1. Appareil pour déterminer le changement d'impédance d'un ou plusieurs éléments (5; 17) possédant un paramètre de vieillissement électromagnétique, comprenant :
- un four (1; 13) avec des moyens de chauffage ;
- un support (4; 16) pour l'élément, disposé à l'intérieur du four (1; 13) ;
- un capteur de température (8; 15) disposé à l'intérieur du four (1; 13) ;
- une ouverture de passage aménagée dans le four pour le passage des fils à connecter (7; 24) à l'élément ; et
- une unité de contrôle (28) qui est connectée au capteur de température (8; 15) et aux moyens de chauffage pour contrôler la température à l'intérieur du four, caractérisé en ce que
- le four (1; 13) a une forme essentiellement tubulaire et une seule paroi fine ;
- les moyens de chauffage comportent un fil de chauffage (3; 14) étroitement enroulé autour du four ; et
- l'alimentation électrique du fil de chauffage (3; 14) est contrôlée par l'unité de contrôle de façon à obtenir pour la température à l'intérieur du four tubulaire une précision de 0,001°C.

2. Méthode pour déterminer le changement d'impédance d'un paramètre de vieillissement électromagnétique dans un ou plusieurs éléments (5; 17) ayant un tel paramètre, caractérisée en ce que l'élément (5; 17) est placé dans un four (1; 13) à une température prédéterminée, en ce qu'une mesure de l'impédance des éléments à cette température est accomplie, et en ce que les changements de température enregistrés par un capteur de température (8; 15) à l'intérieur du four sont retransmis aux moyens de chauffage pour chauffer le four, caractérisée en ce que le chauffage est effectué au moyen d'un fil de chauffage (3; 14) étroitement enroulé autour du four (1; 13) de forme essentiellement tubulaire et ayant une seule paroi fine, et en ce que la température de l'intérieur du four est régulée par une unité de contrôle avec une précision de la température à l'intérieur du four de 0,001°C.

3. Appareil selon la revendication 1, caractérisé en ce que la paroi fine est en acier inoxydable.

4. Appareil selon l'une quelconque des revendications 1 ou 2, caractérisé en ce que le capteur de température est une résistance en Pt.

5. Appareil selon l'une quelconque des revendications 1, 2 ou 3, caractérisé en ce qu'il est équipé d'un second four pour produire une atmosphère humidifiée à l'intérieur du premier four.
